## Europäisches Patentamt
## European Patent Office
## Office européen des brevets

(11) Publication number: **0 139 587**
**B1**

(12) **EUROPEAN PATENT SPECIFICATION**

(45) Date of publication of patent specification: **02.01.91**

(51) Int. Cl.⁵: **H 01 L 21/76, H 01 L 21/82**

(21) Application number: **84402044.6**

(22) Date of filing: **11.10.84**

(54) Fabrication process for a dielectric isolated complementary ic.

(30) Priority: **12.10.83 JP 191181/83**

(43) Date of publication of application:
**02.05.85 Bulletin 85/18**

(45) Publication of the grant of the patent:
**02.01.91 Bulletin 91/01**

(84) Designated Contracting States:
**DE FR GB**

(56) References cited:
**EP-A-0 140 749**
**US-A-4 408 386**

(73) Proprietor: **FUJITSU LIMITED**
**1015, Kamikodanaka Nakahara-ku**
**Kawasaki-shi Kanagawa 211 (JP)**

(72) Inventor: **Tani, Satoru**
**302-13, Aza Ushigahaka Ohaza Yahaka**
**Ikkimachi**
**Aizuwakamatsu-shi Fukushima 965 (JP)**

(74) Representative: **Descourtieux, Philippe et al**
**CABINET BEAU de LOMENIE 55 rue**
**d'Amsterdam**
**F-75008 Paris (FR)**

## Description

### Background of the Invention

The present invention relates to a fabrication process for a dielectric isolated complementary integrated circuit (IC), and more particularly to an improvement of the fabrication process for dielectric isolated regions in which the complementary transistors are fabricated.

### Description of the Prior Art

From the beginning of circuit integration, the isolation between the circuit elements has been a matter of great concern. Air isolation, dielectric isolation and junction isolation were main streams of development. Among them, the junction isolation has been most successful and is now widely used. The dielectric isolation which consists in isolating the circuit elements from each other by means of a dielectric film, such as a silicon dioxide ($SiO_2$) film, has had previously only a limited use although it provides the advantages of small stray capacity and high breakdown voltage. This is mainly due to the difficulty of the fabrication process for dielectric isolated devices, because it requires removing the greater part of the substrate by lapping or polishing, and it is difficult to align a pattern on a surface of the substrate deeply grooved for isolation. All these facts cause the decrease of the yield and the increase of the cost of the IC.

However, recently the demand for high voltage devices increased, the IC being widely used in electronic equipments. As an example, a subscriber line interface circuit (SLIC) which is used for electronic telephone switching equipment is required to stand for several hundreds volts Moreover, it must be a complementary IC, which comprises pnp and npn type transistors. For such applications, especially for fabricating complementary IC circuits, the dielectric isolation process has therefore been reconsidered.

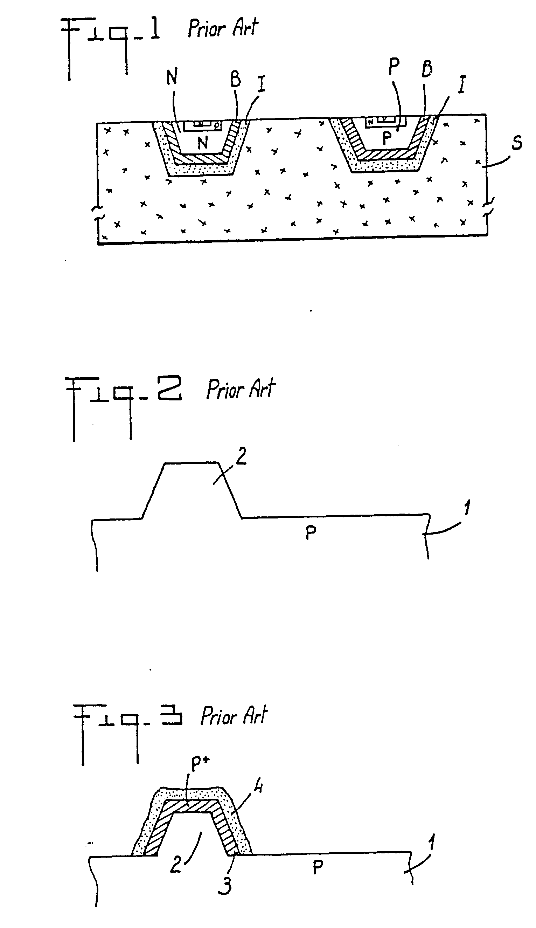

In order to render clearly apparent the advantage of the present invention, a prior art process for fabricating a dielectric isolated complementary IC as shown in Fig. 1 will be described briefly. Fig. 1 is a partial cross sectional view showing schematically the construction of an exemplary IC comprising dielectric isolated complementary transistors. Such an isolated structure is sometimes named an epitaxially passivated integrated circuit (EPIC) and is well known since the early stage of the IC (for example U.S. Pat. No. 3,966,577 of June 29, 1976, by A. K. Hochberg: Dielectrically Isolated Semiconductor Devices).

In Fig. 1, the symbol P designates a p-type semiconductor region in which a pnp transistor is fabricated, and N is an n-type region in which an npn transistor is fabricated. The symbol I designates a silicon dioxide layer, B designates buried layers and S is a poly-silicon (poly crystalline silicon) substrate. The fabrication process is as follows.

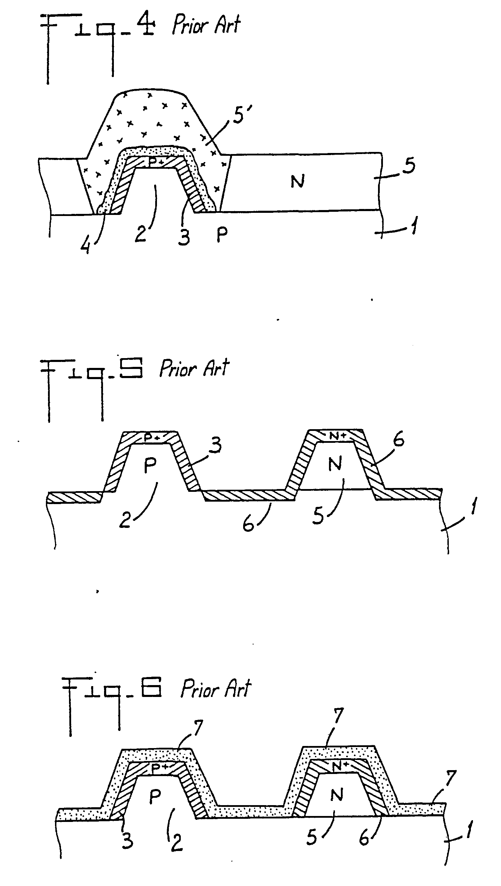

Referring to Fig. 2 a projecting island region 2 is fabricated on a p-type silicon substrate 1. Such a projection is obtained by selective etching, that is, the portion on which the island 2 should be made is firstly coated by a silicon-nitride ($Si_3N_4$) film (not shown) and the remaining portion is etched off. It is known that, when a silicon surface of <100> orientation is etched in potassium hydroxide solution, the difference of etching speed for a different orientation of crystal results in an island-like projection 2 shown in Fig. 2. Such an anisotropic etching is sometimes called V-cut. Fig. 2 shows the state once silicon nitride film covering the island 2 has been removed.

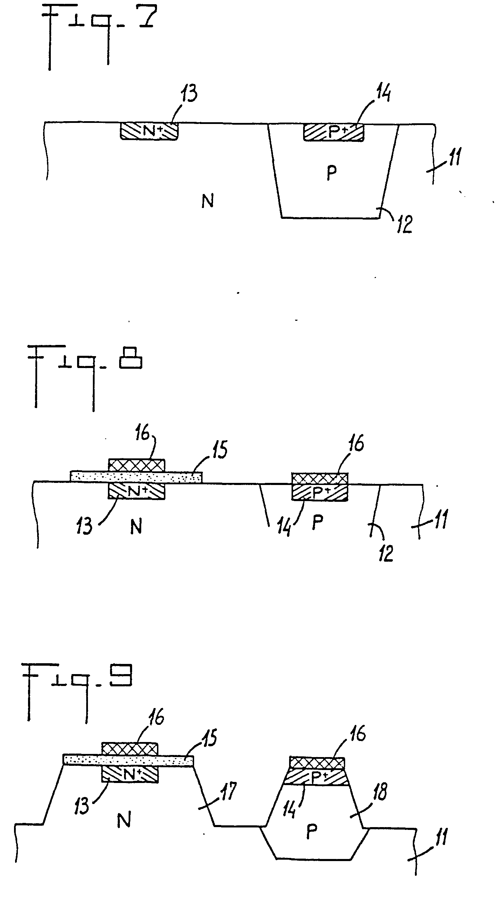

Next, as shown in Fig. 3, the surface of the substrate 1 is coated again by a silicon nitride film (not shown), excepting the portion of the island 2, and the surface region of the island 2 is doped with boron by ion implantation using the silicon nitride film as a mask. Then, by annealing the substrate, the surface region of the island 2 is converted to a p-type region 3. The surface of the substrate is heated again in a wet ambience, and a thick silicon dioxide ($SiO_2$) coating film 4 is grown on the surface of the island 2 as shown in Fig. 3. Finally, the silicon nitride film covering the surface of the substrate 1 is removed. These are processes of the photolithographic type widely used in semiconductor fabrication. Of course, many modifications may be made, such as using a silicon dioxide film instead of silicon nitride film. Difficulties occurring with such a dielectric isolation process are caused by the difference of level between the top of the island 2 and the surface of the substrate 1. For example, the height of the island 2 projected from the surface of the substrate 1 is approximately 40 µm; therefore, the mask alignment for patterning becomes difficult, and the uniformity of such a deep etching also causes problems.

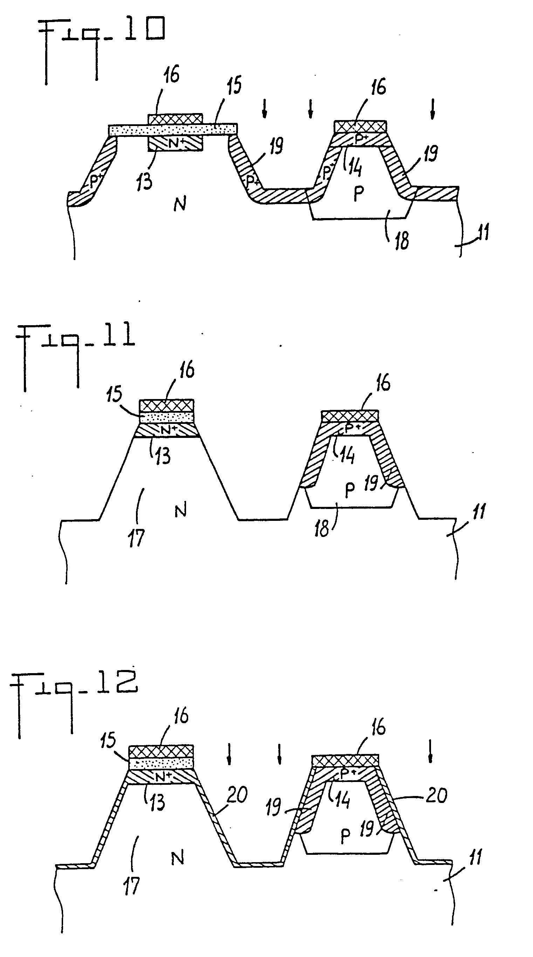

Over such a substrate having projecting islands 2, an n-type semiconductor layer 5 is grown epitaxially as shown in Fig. 4. At this time, the newly grown n-type epitaxial layer 5 loses its crystal structure at the portion located over the silicon dioxide which has an amorphous structure, and becomes amorphous poly-crystalline silicon (poly-silicon). As a result, the island portion 2 of the substrate 1 is coated with a polysilicon 5', but the remaining part is covered with an n-type single crystal layer 5 as shown in Fig. 4.

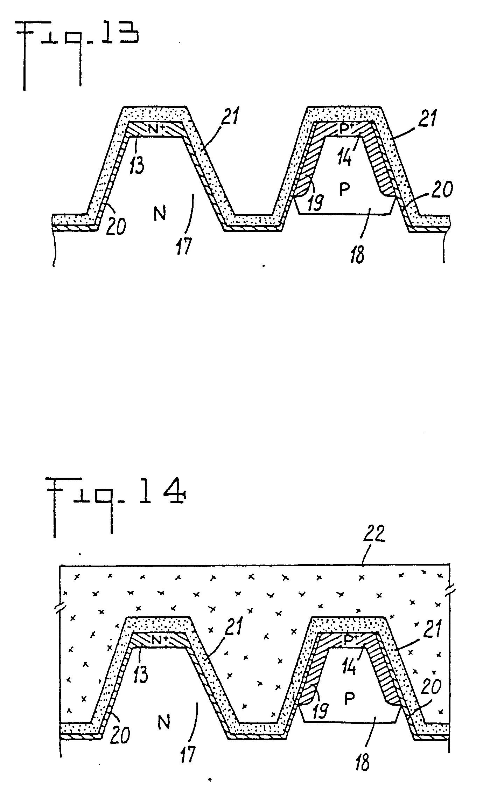

After removing the part of the polysilicon layer projecting from the surface of the n-type epitaxial layer 5, a process similar to the one described with respect to Figs. 2 and 3 is repeated over the n-type layer 5. Namely, by using a silicon nitride film mask (not shown), where the substrate is selectively etched off (V-cut) leaving a new island portion 5 as shown in Fig. 5. In this process, the polysilicon layer covering the first island 2 is also etched off, but the silicon dioxide layer 4 is not etched by an etchant used for silicon, and still remains over the first island 2, though it is not shown in the figure. Using this silicon dioxide layer 4 as a mask, an n-type dopant such as phosphor or arsenic is implanted by ion implantation technology in the surface region of the substrate, and a high doped $n^+$ buried layer 6 is formed by annealing. Then, the silicon dioxide layer 4 is removed by a hydrofluoric acid and the substrate is obtained as shown in Fig. 5.

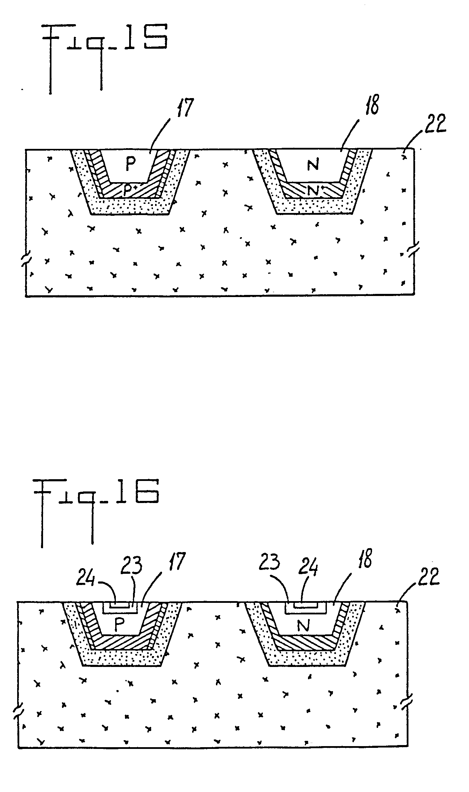

Next, as shown in Fig. 6, a silicon dioxide layer 7 of about $2\mu$ m thick is formed over the surface of the substrate by heating the substrate in oxygen gas or by chemical vapor deposition (CVD). This silicon dioxide layer 7 covering the islands 2 and 5 is later used as the dielectric insulation layer I (Fig. 1) isolating the semiconductor device. Then, a poly-silicon layer is deposited over the entire surface of the substrate 1, and, finally, the substrate 1 is lapped off, leaving the portions of the islands 2 and 5. Thus, a substrate as shown in Fig. 1 is obtained. The above explanation has been given emphasizing the process sequences which are of interest with respect to the present invention, but all the sequences are conventional for semiconductor manufacturing, hence the details have been omitted.

Problems of the Prior Art

As it has been described above, it is necessary to form the p-type and the n-type islands in sequence, and the projection of these islands from the surface of the substrate is very high. Occasionally it exceeds several tens of $\mu$m. Such level differences on the substrate surface presents difficulties in the patterning and etching of the substrate. In order to overcome this problem, a photo-resist coating can be applied several times, and the patterning and etching can also be repeated several times. But such a solution still appears to be inadequate and the lack of uniformity in the thickness of the photoresist results in an uneven etching.

It is also necessary to provide an additional step for removing the projecting portion of the poly-silicon formed on the island 2 by grinding, etching or polishing, and such an additional process step decreases the yield and increases the cost of the IC.

As it has been described, the prior art does not provide a satisfactory solution to overcome the above difficulties, making it necessary to repeat the process of island making and to dope the surface for p-type and n-type islands separately. This is why the yield of conventional dielectric isolated complementary IC is insufficient and the fabrication cost relatively high.

Summary of the Invention

Therefore, it is the object of the present invention to provide an improved process for fabricating a dielectric isolated IC especially for fabricating a complementary IC.

It is also an object of the present invention to provide a process for fabricating regions isolated from other parts of the complementary IC by a dielectric material.

A further object of the present invention is to provide a process which permits to achieve the patterning of said isolated regions on a planar surface.

Still another object of the present invention is to provide a process which is easily carried out and which makes it possible to increase the yield of the dielectric isolated complementary IC obtained.

These objects are achieved by using the method according to the invention, as defined in claim 1.

The invention will be more readily understood from the following description made in connection with the attached drawings.

Brief Description of the Drawings

The drawings show fabrication process steps for dielectric isolated complementary IC, illustrating schematically the cross sectional structure of a substrate at each step. Figs. 1—6 relate to a prior art process, while Figs. 7—16 relate to a process according to the present invention. Throughout the drawings, like reference characters designate like or corresponding parts. More particularly:

Fig. 1 shows the structure of exemplary dielectric isolated complementary IC.

Fig. 2 shows a step in which a p-type projecting island is fabricated on a p-type substrate.

Fig. 3 shows a step in which the surface of the island is doped and coated by a silicon dioxide film.

Fig. 4 shows a step in which an n-type layer is grown on the surface of the substrate.

Fig. 5 shows a step in which another projecting island of n-type is fabricated and its surface is doped.

Fig. 6 shows a step in which the surface of the substrate is coated by a silicon dioxide film.

Fig. 7 shows a step in which a p-type well is fabricated in an n-type substrate, and a part of the surface of the substrate is doped.

Fig. 8 shows a step in which the surface of the substrate is coated by a silicon dioxide film and a silicon nitride film.

Fig. 9 shows a step in which the substrate is etched and p-type and n-type islands are fabricated simultaneously.

Fig. 10 shows a step in which the surface of the substrate is doped with p-type dopant.

Fig. 11 shows a step in which the surface of the substrate is further etched, and the n-type island is reshaped.

Fig. 12 shows a step in which the surface of the substrate is doped with n-type dopant.

Fig. 13 shows a step in which the surface of the substrate is coated with a silicon dioxide film.

Fig. 14 shows a step in which a poly-silicon layer is grown over the surface of the substrate.

Fig. 15 shows a step in which the silicon substrate is lapped off and the remaining parts are turned upside down.

Fig. 16 shows a step in which pnp and npn transistors are fabricated in respective isolated regions.

Detailed Description of the Invention

As mentioned above, the present invention is intended to allow the formation of p-type and n-type islands simultaneously, and to prevent the repetition of deep etching which occasionally causes problems. It also intends to avoid performing mask alignment over a surface showing large level differences, to maintain the sharpness of the mask and to obtain a uniform photo-lithograph. Details of a process according to the present invention will be disclosed in connection with the accompanying drawings.

This process begins with the preparation of an n-type silicon substrate having a <100> oriented surface. The disclosure will be given with respect to an n-type substrate, but it will be clear for those skilled in the art that the process may be easily modified to use a p-type substrate. As shown in Fig. 7, a p-type well 12 is formed in an n-type substrate 11 whose surface has a crystal orientation <100>. On the surface of the substrate 11 where the npn and pnp transistors are to be made, an $n^+$ region 13 and $p^+$ region 14 are fabricated respectively on the p-type and n-type region (well) as shown in the figure. (These highly doped regions will form later the buried layers of the isolated regions). The highly doped regions 13 and 14 are fabricated by ordinary semiconductor fabrication processes such as photo-lithograph patterning of a photoresist film or an isolation film, and with the use of diffusion or ion implantation technologies.

On the surface of the substrate are formed a silicon dioxide ($SiO_2$) film 15 which is called as the first isolation film, and a silicon nitride ($Si_3N_4$) film 16 which is called as the second isolation film. These isolation films are patterned as shown in Fig. 8, by applying an ordinary photolithographic technology. The first isolation film 15 is formed over the highly doped region 13 and is patterned larger than said region 13. The second isolation film 16 has the same size as that of the highly doped regions 13 and 14, and is positioned just over each of the highly doped regions respectively above the first isolation film 15 and the highly doped region 14. The first isolation film 15 is then located between the substrate 11 and the second isolation film 16 and extends approximately 5 µm wide from the periphery of region 13 and film 16, as shown in the figure.

As one of the features of the present invention, it should be pointed out that the mask aligning and photo-lithographic etching operations used in the processes hereinbefore are performed all in a planar surface of the substrate; therefore, the resolution of the patterns is not damaged by the unevenness of the surface, and in the processes hereinafter, photo-lithography will not be used until the p-type and n-type isolation regions have been completed.

The exposed part of the substrate outside the isolation films is then etched in a potassium hydroxide solution and an n-type island 17 and a p-type island 18 are fabricated simultaneously as shown in Fig. 9. As mentioned before, this is another feature of the present invention. It is already known that the silicon surface of <100> orientation is anisotropically etched, while the surfaces of <100> orientation of the side walls of the islands are practically not etched. Thus, trapezoidal islands having the flat isolation films 15 or 16 on their top surfaces are formed.

After the etching process, the surface of the substrate is doped with boron of a dose of $10^{16}$ by ion implantation with an acceleration voltage or for instance, 70 KeV. This time, the isolation films 15 and 16 are used as a mask. By annealing the substrate, the exposed surface of the substrate exposed outside the isolation films 15 and 16 is converted to a highly doped $p^+$ layer 19 as shown in Fig. 10.

Then, the portion of the silicon dioxide film 15 exposed outside the silicon nitride film 16 in Fig. 10 is removed by fluoric acid, and the substrate is again etched by caustic potash using the silicon nitride film 16 as a mask. Thereafter, by anisotropic etching, the n-type island and the $p^+$ regions on its side wall and on the bottom of the islands are etched, causing the islands to be reshaped as shown in Fig. 11.

Then, as shown in Fig. 12, arsenic is implanted on the surface of the substrate with a dose of $8 \times 10^{15}$ and an acceleration energy of 70 Kev. This time, the isolation film 16 is again used as a mask. By heat treatment, the surface of the substrate and the side wall of the islands are converted to an $n^+$ layer 20. The thickness of the $n^+$ layer 20 is thinner compared to that of the $p^+$ layer 19, owing to the difference of the diffusion coefficient of boron and arsenic. (The diffusion coefficient of the former is much higher than that of the latter). So, the $p^+$ layer 19 remains under the $n^+$ layer 20, as shown in Fig. 12. For example, when the thickness of the $p^+$ layer 19 is 5 µm the thickness of the $n^+$ layer 20 is no more than 2 µm. There-fore, the $p^+$ region 19 of the p-type island 18 remains at least 3 µm thick which is enough to be used as a buried layer from the p-type region 18.

After removing the silicon nitride film 16 and the silicon dioxide film 15, the substrate is treated in an oxidizing gas at 1000°C, and an insulation film such as a $SiO_2$ film 21 of 2.5—3 µm thick is formed over the surface of the substrate as shown in Fig. 13.

Then as shown in Fig. 14, a polysilicon layer 22 of several hundred µm thick is grown on the surface of the substrate by chemical vapor deposition. Finally, almost all of the substrate 11 is lapped off or polished away from its back surface (it may be etched off). When the substrate is turned upside down, it becomes as shown in Fig. 15. As shown in this figure, the p-type and n-type isolated regions 17 and 18 are fabricated in a new poly-silicon substrate 22. They are respectively surrounded by $p^+$ and $n^+$ type buried layers and isolated from each other by a silicon dioxide layer and poly-silicon material.

Thus the fabrication process of the isolated regions is finished, and the substrate on which a dielectric isolated IC is to be made, is prepared. Since the surface of the substrate is flat, the fabrication of the circuit components of the IC is simple. Fig. 16 shows a state in which bases 23 and emitters 24 are fabricated, and pnp and npn transistors are fabricated respectively on the p-type and n-type isolated regions. They can be fabricated by using conventional semiconductor fabrication technology. After the transistors are wired correctly with wiring layers (not shown) and the surface is coated with passivation films, the dielectric isolated complementary IC is complete.

As it has been disclosed above, according to the process of the present invention, all the patterns including the silicon dioxide film 15 and silicon nitride film 16 used to fabricate the IC are aligned and formed on a flat surface of the substrate; therefore, the accuracy of the pattern is very high. Additionally, the deep etching to form the isolated islands is done in a single etching process. Both the packing density of the IC elements and the yield are thus improved to a great extent, and the cost of the dielectric isolated complementary IC is very much decreased.

The above disclosure has been made with respect to the fabrication of a dielectric isolated complementary IC, but it will be clear that the application of the present invention is not limited to a complementary IC; it can be applied to any kind of semiconductor device having dielectric isolated circuit elements in its substrate (not claimed). If it is used to fabricate a device which includes only one type of transistor, npn transistor for example, the processes can be simplified, by eliminating several steps for fabricating the walls or islands of opposite type conductivity in the substrate (not claimed). The present invention can also be applied to a case where a substrate has not only an n-type (or p-type) isolated region (or island) surrounded by $n^+$ (or $p^+$) type buried layer, but also an n-type (or p-type) region (or island) surrounded by $p^+$ (or $n^+$) buried layer.

In the above disclosure, the explanation has been given with respect to an n-type silicon substrate, but it is clear that the process can be easily modified to be applied to a p-type substrate. Moreover, the process can be performed by using any conventional semiconductor manufacturing technology and, therefore, many modifications can be made without departing from the scope of the present invention; for example, the ion implantation process can be replaced by a diffusion process, and the thermal oxidation process may be replaced by a chemical vapor deposition process, and so on.

**Claims**

1. A method for fabricating a dielectric isolated complementary IC on a planar substrate having a specific orientation comprising the following steps:

a) providing wells (12) of a second conductivity type in a first conductivity type substrate (11);

b) providing first high doped regions (13) of first conductivity type, outside the region of said wells and second high doped regions (14) of second conductivity type within the region of said wells at portions on the surface of said substrate where first and second conductivity type isolated regions should be respectively made;

c) covering said first high doped regions (13) with a first isolation film (15) made of a first material which is patterned larger than the first high doped regions (13);

d) covering said first and second high doped regions (13, 14) with a second isolation film (16) made of a second material which is patterned equal to the pattern of each high doped regions to cover, said second isolation film (16) being formed on the first isolation film (15) over the first high doped regions (13);

e) etching the exposed surface of the substrate outside said first and second isolation films and fabricating islands (17, 18) which project from the surface of the substrate (11) under the isolation films (15, 16);

f) doping the surface of the substrate (11) with a second conductivity type impurity having a first diffusion coefficient using the first and second isolation films (15, 16) as a mask;

g) etching off the portion of the first isolation film (15) exposed from the second isolation film (16);

h) etching off the portion of substrate which is exposed from the removed part of the first isolation film (15) by step g);

i) doping the surface of the substrate with a first conductivity type impurity having a second diffusion coefficient that is smaller than said first diffusion coefficient, using the second isolation film (16) as a mask;

j) removing the first and second isolation films (15, 16);

k) forming a third isolation film (21) over the surface of the substrate;

l) growing a polysilicon layer (22) over the surface of the substrate; and

m) removing the substrate from its back surface leaving the island portions (17, 18) in the polysilicon layer (22).

2. A method for fabricating a dielectric isolated complementary IC according to claim 1, characterized in that the material of said substrate (11) is a silicon and said first and second conductivity type are respectively n-type and p-type conductivity, or vice versa.

3. A method for fabricating a dielectric isolated complementary IC according to claim 1, characterized in that the first isolation film (15) is a silicon dioxide film, and the second isolation film (16) is a silicon nitride film.

4. A method for fabricating a dielectric isolated complementary IC according to claim 1, characterized in that the processes e) and h) comprise anisotropic etching using potassium hydroxide solution as an etchant.

5. A method for fabricating a dielectric isolated complementary IC according to claim 1, characterized in that the dopants used in the processes f) and i) are boron and arsenic respectively.

6. A method for fabricating a dielectric isolated complementary IC according to claim 1, characterized in that the processes f) and i) comprise an ion implantation.

7. A method for fabricating a dielectric isolated complementary IC according to claim 1, characterized in that the process k) comprises a thermal oxidation process and the third isolation film (21) formed by the process k) is a silicon dioxide film.

8. A method for fabricating a dielectric isolated complementary IC according to claim 1, characterized in that the process m) comprises lapping, polishing or etching the substrate.

9. A method for fabricating a dielectric isolated complementary IC according to claim 1, characterized in that each of said first isolation film (15) extends approximately five µm wide from the periphery of said first high doped region (13).

## Patentansprüche

1. Verfahren zur Herstellung einer dielektrisch isolierten complementären IC auf einem planaren Substrat, das eine spezifische Orientierung hat, mit den folgenden Schritten:

a) Bilden von Gräben (12) von einem zweiten Leitfähigkeitstyp in einem Substrat (11) von einem ersten Leitfähigkeitstyp;

b) Vorsehen erster hochdotierter Bereiche (13) von einem ersten Leitfähigkeitstyp, außerhalb des Bereichs der genannten Gräben, und zweiter hochdotierter Bereiche (14) von einem zweiten Leitfähigkeitstyp innerhalb des Bereiches der genannten Gräben an Abschnitten an der Oberfläche des genannten Substrates, wo isolierte Bereiche vom ersten bzw. zweiten Leitfähigkeitstyp hergestellt werden sollten;

c) Bedecken der genannten ersten hochdotierten Bereiche (13) mit einem ersten Isolationsfilm (15), der aus einem ersten Material besteht, der größer als die genannten ersten hochdotierten Bereiche (13) gemustert ist;

d) Bedecken der genannten ersten und zweiten hochdotierten Bereiche (13, 14) mit einem zweiten Isolationsfilm (16) aus einem zweiten Material, der gleich dem Muster von jedem der zu bedeckenden hochdotierten Bereiche gemustert ist, wobei der genannte zweite Isolationsfilm (16) auf dem ersten Isolationsfilm (15) über den ersten hochdotierten Bereichen (13) gebildet wird;

e) Ätzen der exponierten Oberfläche des Substrates außerhalb der genannten ersten und zweiten Isolationsfilme und Herstellen von Inseln (17, 18), welche von der Oberfläche des Substrats (11) unter den Isolationsfilmen (15, 16) vorstehen;

f) Dotieren der Oberfläche des Substrats (11) mit einer Verunreinigung von einem zweiten Leitfähigkeitstyp, welcher einen ersten Diffusionskoeffizienten hat, unter Verwendung der ersten und zweiten Isolationsfilme (15, 16) als eine Maske;

g) Wegätzen des Abschnittes des ersten Isolationsfilms (15), welcher von dem zweiten Isolationsfilm (16) freigelegt ist;

h) Wegätzen eines Abschnittes des Substrates, welcher von dem entfernten Teil des ersten Films (15) freigelegt ist, durch den Schritt g);

i) Dotieren der Oberfläche des Substrates mit einer Verunreinigung von einem ersten Leitfähigkeitstyp, die einen zweiten Diffusionskoeffizienten hat, der kleiner als der genannte erste Diffusionskoeffizient ist, unter Verwendung des genannten Isolationsfilms (16) als eine Maske;

j) Entfernen der ersten und zweiten Isolationsfilme (15, 16);

k) Bilden eines dritten Isolationsfilmes (21) über der Oberfläche des Substrates;

l) Wachsen einer polykristallinen Schicht (22) über der Oberfläche des Substrates; und

m) Entfernen des Substrates von seiner Rückoberfläche, wobei die Inselabschnitte (17, 18) in der Polysiliciumschicht (22) gelassen werden.

2. Verfahren zur Herstellung einer dielektrisch isolierten komplementären IC nach Anspruch 1, dadurch gekennzeichnet, daß das Material des genannten Substrates (11) ein Silicium ist und der genannte erste und zweite Leitfähigkeitstyp der n- bzw. p-Leitfähigkeitstyp ist, oder umgekehrt.

3. Verfahren zur Herstellung einer dielektrisch isolierten komplementären IC nach Anspruch 1, dadurch gekennzeichnet, daß der erste Isolationsfilm (15) ein Siliciumdioxidfilm ist, und der zweite Isolationsfilm (16) ein Siliciumnitridfilm ist.

4. Verfahren zur Herstellung einer dielektrisch isolierten komplementären IC nach Anspruch 1, dadurch gekennzeichnet, daß die Verfahrensschritte e) und h) anisotropes Ätzen unter Verwendung einer Kaliumhydroxidlösung als Ätzmittel umfassen.

5. Verfahren zur Herstellung einer dielektrisch isolierten komplementären IC nach Anspruch 1, dadurch gekennzeichnet, daß die Dotierungen, die bei den Verfahrensschritten f) und i) verwendet werden, Bor bzw. Arsen sind.

6. Verfahren zur Herstellung einer dielektrisch isolierten komplementären IC nach Anspruch 1, dadurch gekennzeichnet, daß die Verfahrensschritte f) und i) eine Ionenimplantation umfassen.

7. Verfahren zur Herstellung einer dielektrisch isolierten komplementären IC nach Anspruch 1, dadurch gekennzeichnet, daß der Verfahrensschritt k) einen thermischen Oxidationsprozeß umfaßt und der dritte Isolationsfilm (21), der durch den Verfahrensschritt k) gebildet wird, ein Siliciumdioxidfilm ist.

8. Verfahren zur Herstellung einer dielektrisch isolierten komplementären IC nach Anspruch 1. dadurch gekennzeichnet, daß der Verfahrensschritt m) das Läppen, Polieren oder Ätzen des Substrates umfaßt.

9. Verfahren zur Herstellung einer dielektrisch isolierten komplementären IC nach Anspruch 1, dadurch gekennzeichnet, daß jeder genannte erste Isolationsfilm (15) sich angenähert 5 µm weit von dem Umfang des genannten ersten hochdotierten Bereiches erstreckt.

## Revendications

1. Procédé permettant de fabriquer un circuit intégré complémentaire isolé par diélectrique sur un substrat plan possédant une orientation particulière, qui comprend les opérations suivantes:

a) produire des puits (12) d'un deuxième type de conductivité dans un substrat (11) d'un premier type de conductivité;

b) produire des premières régions fortement dopées (13) du premier type de conductivité à l'extérieur de la région desdits puits et des deuxièmes régions fortement dopées (14) du deuxième type de conductivité à l'intérieur de la région desdits puits en des parties de la surface dudit substrat où des régions isolées du premier type et du deuxième type de conductivité doivent être respectivement fabriquées;

c) recouvrir lesdites premières régions fortement dopées (13) à l'aide d'une première pellicule d'isolation (15) faite d'un premier matériau, qui est configurée de façon à être plus grande que les premières régions fortement dopées (13);

d) recouvrir lesdites premières et deuxièmes régions fortement dopées (13, 14) à l'aide d'une deuxième pellicule d'isolation (16) faite d'un deuxième matériau, qui est configurée de façon à être égale à la configuration de chaque région fortement dopée à recouvrir, ladite deuxième pellicule d'isolation (16) étant formée sur la première pellicule d'isolation (15) au-dessus des premières régions fortement dopées (13);

e) graver la surface exposée du substrat qui est à l'extérieur des première et deuxième pellicules d'isolation et fabriquer des îlots (17, 18) qui font saillie de la surface du substrat (11) au-dessous des pellicules d'isolation (15, 16);

f) doper la surface du substrat (11) à l'aide d'une impureté du deuxième type de conductivité possédant un premier coefficient de diffusion en utilisant les première et deuxième pellicules d'isolation (15, 16) comme masque;

g) enlever par gravure la partie de la première pellicule d'isolation (15) qui est exposée relativement à la deuxième pellicule d'isolation (16);

h) retirer par gravure la partie du substrat qui est exposée par rapport à la partie retirée de la première pellicule d'isolation (15) au cours de l'opération g);

i) doper la surface du substrat à l'aide d'une impureté du premier type de conductivité qui possède un deuxième coefficient de diffusion qui est plus petit que ledit premier coefficient de diffusion, en utilisant la deuxième pellicule d'isolation (16) comme masque;

j) retirer les première et deuxième pellicules d'isolation (15, 16);

k) former une troisième pellicule d'isolation (21) au-dessus de la surface du substrat;

l) faire croître une pellicule de silicium polycristallin (22) sur la surface du substrat; et

m) retirer le substrat depuis sa surface arrière de façon à laisser les parties îlots (17, 18) dans la couche de silicium polycristallin (22).

2. Procédé de fabrication d'un circuit intégré complémentaire isolé par diélectrique selon la revendication 1, caractérisé en ce que la matière dudit substrat (11) est le silicium et lesdits premier et deuxième types de conductivité sont respectivement le type n et le type p, ou bien inversement.

3. Procédé de fabrication d'un dispositif complémentaire isolé par diélectrique selon la revendication 1, caractérisé en ce que la première pellicule d'isolation (15) est une pellicule de dioxyde de silicium, et la deuxième pellicule d'isolation (16) est une pellicule de nitrure de silicium.

4. Procédé de fabrication d'un circuit intégré complémentaire isolé par diélectrique selon la revendication 1, caractérisé en ce que les opérations e) et h) comprennent une gravure anisotrope utilisant une solution d'hydroxyde de potassium comme agent de gravure.

5. Procédé de fabrication d'un circuit intégré complémentaire isolé par diélectrique selon la revendication 1, caractérisé en ce que les agents dopant utilisés dans les opérations f) et i) sont respectivement le bore et l'arsenic.

6. Procédé de fabrication d'un circuit intégré complémentaire isolé par diélectrique selon la revendication 1, caractérisé en ce que les opérations f) et i) comprennent une implantation ionique.

7. Procédé de fabrication d'un circuit intégré complémentaire isolé par diélectrique selon la revendication 1, caractérisé en ce que l'opération k) comprend une opération d'oxydation thermique et la troisième pellicule d'isolation (21) formée par l'opération k) est une pellicule de dioxyde de silicium.

8. Procédé de fabrication d'un circuit intégré complémentaire isolé par diélectrique selon la revendication 1, caractérisé en ce que l'opération m) consiste à roder, à polir ou à graver le substrat.

9. Procédé de fabrication d'un circuit intégré complémentaire isolé par diélectrique selon la revendication 1, caractérisé en ce que chacune de ladite première pellicule d'isolation (15) s'étend à environ 5 µm de large vis-à-vis de la périphérie de ladite première région fortement dopée (13).

EP 0 139 587 B1

Fig-1  *Prior Art*

Fig-2  *Prior Art*

Fig-3  *Prior Art*

1

Fig_4 *Prior Art*

5'

P+

N 5

4 2 3 P 1

Fig_5 *Prior Art*

P+ 3 N+ 6

P N

2 6 5 1

Fig_6 *Prior Art*

7 7

P+ N+

P N 7

3 2 5 6 1

Fig. 7

13

N⁺

14

P⁺

P

11

N

12

Fig. 8

16

15

16

N⁺

P⁺

13    N

14    P

11

12

Fig. 9

16

15

16

N⁺

P⁺

13    N

17

14    P

18

11

Fig-10

16    15

N+    19

13    P+    P+    14    19

P+    N    P

18    11

Fig-11

16

15    16

N+

13    P+    14

17    N    P    19

18    11

Fig-12

16    16

15

N+

13    20    19    P+    14    20

17    N    P    19    11

Fig_13

N⁺ 21
13
N
17
20
P⁺ 14
19 P
18
20

Fig_14

22
N⁺ 21
13
N
17
20
P⁺ 14
19 P
18
20

# Fig. 15

# Fig. 16